# EUROPÄISCHE PATENTSCHRIFT

(11) **EP 2 673 787 B1**
(45) Veröffentlichungstag und Bekanntmachung des Hinweises auf die Patenterteilung: **01.01.2020**
(21) Anmeldenummer: 12701912.3
(22) Anmeldetag: 02.02.2012
(51) Int. Cl.: H01C 7/18, H01G 4/012, H01G 4/30

(54) **ELEKTRISCHES KERAMIKBAUELEMENT MIT ELEKTRISCHER ABSCHIRMUNG**
ELECTRIC CERAMIC COMPONENT WITH ELECTRIC SHIELDING
COMPOSANT ÉLECTRIQUE EN CÉRAMIQUE À BLINDAGE ÉLECTRIQUE

(30) Priorität: 08.02.2011 DE 102011010611
(43) Veröffentlichungstag der Anmeldung: 18.12.2013
(73) Patentinhaber: TDK Electronics AG, 81671 München (DE)
(72) Erfinder: FEICHTINGER, Thomas, A-8010 Graz (AT); KRENN, Georg, A-8020 Graz (AT); KUDLATY, Jerzy, A-8042 Graz (AT)
(74) Vertreter: Epping - Hermann - Fischer
(86) Internationale Anmeldenummer: PCT/EP2012/051786
(87) Internationale Veröffentlichungsnummer: WO 2012/107349

(56) Entgegenhaltungen:
- DE-A1- 10 354 026
- JP-A- 2000 133 545
- US-A1- 2007 025 054
- US-A1- 2009 059 469
- US-A1- 2010 271 752

## Beschreibung

Die Erfindung betrifft ein elektrisches Keramikbauelement, insbesondere ein oberflächenmontierbares Vielschichtbauelement, das mit externen elektrischen Anschlüssen und einer elektrischen Abschirmung versehen ist.

In der DE 10 2007 020 783 A1 ist ein elektrisches Vielschichtbauelement beschrieben, das einen Grundkörper mit einem Stapel abwechselnd übereinander angeordneter dielektrischer Schichten und Elektrodenschichten aufweist. Eine elektrisch unkontaktierte metallische Abschirmstruktur ist von dielektrischem Material umgeben und hat die Funktion, Bereiche des Vielschichtbauelements vor Beeinflussung durch externe elektromagnetische Felder, die beispielsweise auf Grund von Streukapazitäten auftreten können, zu schützen.

Es lässt sich oftmals nicht vermeiden, dass elektronische Keramikbauelemente bei der Herstellung und Verwendung schädigenden Einflüssen ausgesetzt werden. Als schädigend sind insbesondere aggressive chemische Stoffe zu nennen, wie zum Beispiel chlorhaltige Verbindungen aus Flussmitteln, die beim Löten verwendet werden. Es wird angenommen, dass die Einwirkung derartiger chemischer Stoffe dazu führt, dass eine im Betrieb des Keramikbauelementes anliegende elektrische Spannung eine Diffusion in den elektrisch aktiven Bereich des Bauelementes bewirkt, wodurch die elektrischen Eigenschaften des Keramikbauelementes nachteilig verändert werden. Um das zu verhindern, werden die Oberflächen der Keramikbauelemente üblicherweise mit einer passivierenden Schicht geschützt.

US 2007/0025054 A1 beschreibt ein Vielschichtbauelement mit Dummy-Elektroden, die über und unter Zuleitungsbereichen von Innenelektroden mit wechselnder Polarität angeordnet und jeweils mit einer Außenelektrode verbunden sind. Damit soll das Auftreten von Rissen in dem Grundkörper verhindert werden.

US 2010/0271752 A1 beschreibt ein Vielschichtbauelement mit Dummy-Elektroden, die über und unter Zuleitungsbereichen von Innenelektroden angeordnet und jeweils mit einer Außenelektrode verbunden sind. Damit soll die Stärke des keramischen Körpers erhöht werden.

US 2009/0059469 A1 beschreibt ein Vielschichtbauelement mit drei Kondensatorbereichen. Innenelektroden des mittleren Kondensatorbereiches sind mit endständigen Außenelektroden verbunden, während Innenelektroden der darüber und darunter angeordneten Kondensatorbereiche mit weiteren Außenelektroden verbunden sind, die in einem mittleren Bereich des Grundkörpers seitlich angeordnet sind.

DE 103 54 026 A1 beschreibt einen piezoelektrischen elektroakustischen Wandler, bei dem eine Innenelektrode in ihrer Schichtebene auf drei Seiten von einer im Abstand dazu angeordneten Dummy-Elektrode rahmenförmig umgeben wird.

JP2000133545 A beschreibt einen keramischen Vielschichtkondensator.

Aufgabe der vorliegenden Erfindung ist es, ein elektrisches Keramikbauelement anzugeben, bei dem eine unerwünschte Veränderung der elektrischen Eigenschaften verhindert oder zumindest stark reduziert ist.

Diese Aufgabe wird mit dem elektrischen Keramikbauelement mit den Merkmalen des Anspruchs 1 gelöst. Ausgestaltungen ergeben sich aus den abhängigen Ansprüchen.

Die Erfindung beruht auf der Erkenntnis, dass unerwünschte Veränderungen der elektrischen Eigenschaften von Keramikbauelementen durch eine Diffusion von Ladungsträgern von den Außenkontakten in den aktiven Bereich hervorgerufen werden können. Um das wirkungsvoll zu verhindern, werden zusätzliche Elektroden vorgesehen, die stets auf demselben elektrischen Potenzial liegen wie die Außenkontakte und die elektrischen Verbindungen, die von den Außenkontakten zu dem inneren aktiven Bereich führen, elektrisch abschirmen.

Das elektrische Keramikbauelement besitzt einen Grundkörper aus dielektrischem Material, in dem ein aktiver Bereich angeordnet ist. Mindestens ein Außenkontakt ist an dem Grundkörper angeordnet. Ein Zuleitungsbereich verbindet den Außenkontakt mit dem aktiven Bereich. Eine Elektrode ist benachbart zu dem Zuleitungsbereich in dem Grundkörper angeordnet und mit dem Außenkontakt, aber nicht mit dem aktiven Bereich, elektrisch leitend verbunden.

Die Elektrode ist als Platte ausgebildet und in einem Abstand zu dem Zuleitungsbereich angeordnet.

Auf einer der Elektrode gegenüberliegenden Seite des Zuleitungsbereiches ist bevorzugt eine weitere Elektrode benachbart zu dem Zuleitungsbereich in dem Grundkörper angeordnet und mit dem Außenkontakt, aber ebenfalls nicht mit dem aktiven Bereich, elektrisch leitend verbunden.

Bevorzugt ist eine Mehrzahl weiterer Elektroden benachbart zu dem Zuleitungsbereich in dem Grundkörper angeordnet und mit dem Außenkontakt, aber nicht mit dem aktiven Bereich, elektrisch leitend verbunden. Die Elektrode und die weiteren Elektroden sind als Platten ausgebildet und in zueinander parallelen Ebenen in Abständen zueinander angeordnet, was im Folgenden als "koplanar" bezeichnet wird, und umgeben den Zuleitungsbereich dort, wo der Zuleitungsbereich weder an den Außenkontakt noch an den aktiven Bereich angrenzt.

Es ist an einer dem Außenkontakt gegenüberliegenden Seite des Grundkörpers ein weiterer Außenkontakt an dem Grundkörper angeordnet und ein weiterer Zuleitungsbereich vorhanden, der den weiteren Außenkontakt mit dem aktiven Bereich verbindet. Eine weitere Elektrode ist benachbart zu dem weiteren Zuleitungsbereich in dem Grundkörper angeordnet und mit dem weiteren Außenkontakt, aber nicht mit dem aktiven Bereich, elektrisch leitend verbunden.

Bei einem weiteren Ausführungsbeispiel sind mehrere weitere Elektroden benachbart zu dem weiteren Zuleitungsbereich in dem Grundkörper angeordnet und mit dem Außenkontakt, aber nicht mit dem aktiven Bereich, elektrisch leitend verbunden. Bei einem weiteren Ausführungsbeispiel bilden die benachbart zu dem Zuleitungsbereich und zu dem weiteren Zuleitungsbereich angeordneten Elektroden eine in Bezug auf den aktiven Bereich symmetrische Anordnung.

Es ist zwischen dem Außenkontakt und dem weiteren Außenkontakt ein mittlerer Außenkontakt an dem Grundkörper angeordnet. Die Bezeichnung "mittlerer Außenkontakt" wird hier und in den Ansprüchen zur Unterscheidung von den vorgenannten Außenkontakten verwendet, die insbesondere an Enden des Grundkörpers angeordnet sein können. Der mittlere Außenkontakt braucht jedoch nicht in der geometrischen Mitte des Keramikbauelementes angeordnet zu sein. Ein in diesem Sinne mittlerer Zuleitungsbereich ist vorhanden, der den mittleren Außenkontakt mit dem aktiven Bereich verbindet. Eine ebenfalls in diesem Sinne mittlere Elektrode ist benachbart zu dem mittleren Zuleitungsbereich in dem Grundkörper angeordnet und mit dem mittleren Außenkontakt, aber nicht mit dem aktiven Bereich, elektrisch leitend verbunden.

Es ist die mittlere Elektrode als Platte ausgebildet und in einem Abstand zu dem mittleren Zuleitungsbereich angeordnet.

Bei einem weiteren Ausführungsbeispiel ist auf einer der mittleren Elektrode gegenüberliegenden Seite des mittleren Zuleitungsbereiches eine weitere mittlere Elektrode benachbart zu dem mittleren Zuleitungsbereich in dem Grundkörper angeordnet und mit dem mittleren Außenkontakt, aber nicht mit dem aktiven Bereich, elektrisch leitend verbunden.

Es folgt eine genauere Beschreibung von Beispielen des piezoelektrischen Vielschichtbauelementes anhand der beigefügten Figuren.

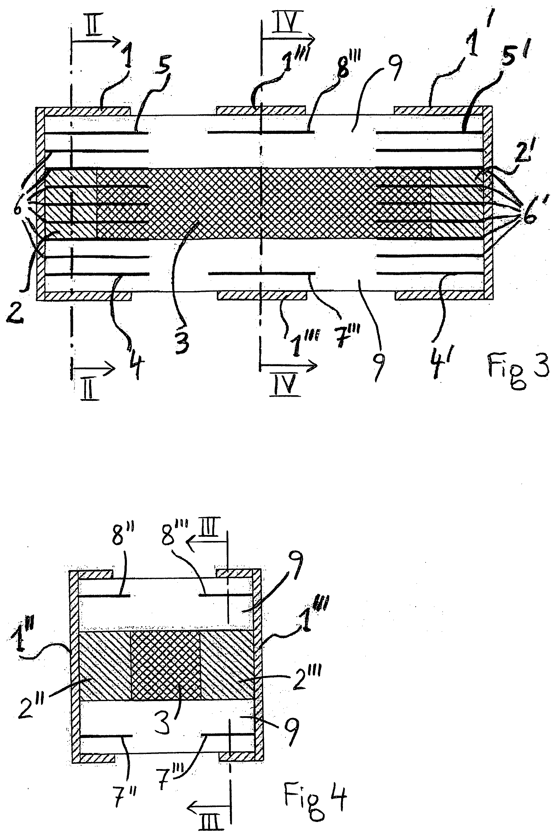

Die Figuren 3 und 4 zeigen ein Ausführungsbeispiel der Erfindung, während die weiteren Figuren lediglich zu deren Verständnis dienen.
- Figur 1: zeigt einen Querschnitt eines Ausführungsbeispiels des Keramikbauelementes.
- Figur 2: zeigt den in der Figur 1 markierten Querschnitt.
- Figur 3: zeigt einen Querschnitt eines weiteren Ausführungsbeispiels.
- Figur 4: zeigt den in der Figur 3 markierten Querschnitt.
- Figur 5: zeigt einen Querschnitt eines weiteren Ausführungsbeispiels.
- Figur 6: zeigt den in der Figur 5 markierten Querschnitt.
- Figur 7: zeigt einen Querschnitt eines weiteren Ausführungsbeispiels.
- Figur 8: zeigt den in der Figur 7 markierten Querschnitt.

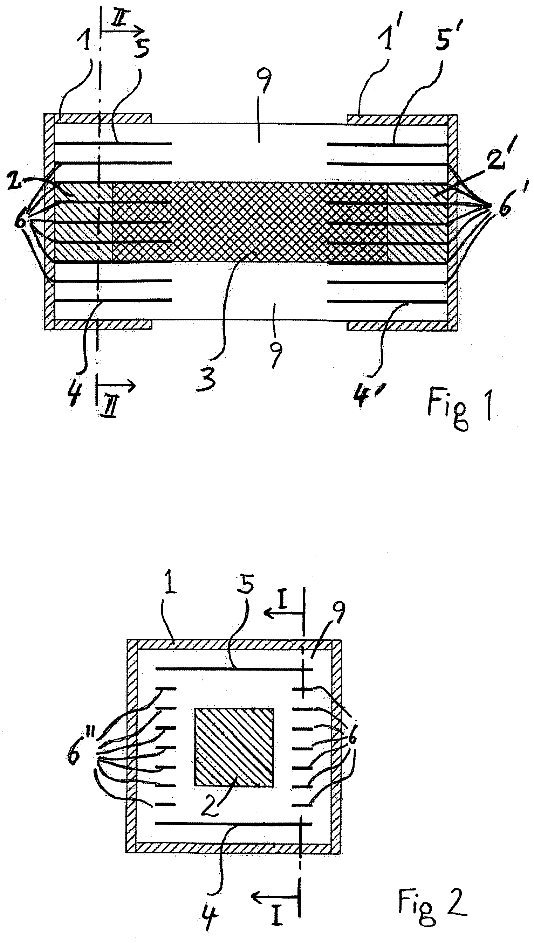

In den Figuren 1, 3, 5 und 7 tragen die auf der linken Seite eingezeichneten Komponenten Außenkontakt, Zuleitungsbereich und Elektroden jeweils Zahlen ohne Strich als Bezugszeichen, während die entsprechenden Komponenten, die auf der rechten Seite eingezeichnet sind, jeweils dieselben Zahlen mit Strich (Apostroph) als Bezugszeichen tragen. In den Figuren 2 und 4 sind die jeweils auf der linken Seite eingezeichneten Komponenten Außenkontakt, Zuleitungsbereich und Elektroden, die sich in den Ansichten der Figuren 1 und 3 hinter der Zeichenebene befinden, jeweils mit Zahlen mit zwei Strichen als Bezugszeichen versehen. Die mit 1''', 2''', 7''', 8''' bezeichneten Komponenten mittlerer Außenkontakt, mittlerer Zuleitungsbereich und mittlere Elektroden sind bei dem Ausführungsbeispiel der Figuren 3 und 4 vorhanden und befinden sich innerhalb der Zeichenebene der Figur 3. In den Figuren 2, 4, 6 und 8 sind die Positionen der in den Figuren 1, 3, 5 beziehungsweise 7 dargestellten Querschnitte markiert. Die Zuleitungsbereiche 2 und 2' sowie der aktive Bereich 3 sind zur Verdeutlichung der Anordnung auch in den Figuren 1, 3, 5 und 7 eingezeichnet, liegen aber hinter der Zeichenebene und sind von dem Material des Grundkörpers 9 verdeckt.

Die Figur 1 zeigt einen Querschnitt eines Ausführungsbeispiels des Keramikbauelementes. Der Grundkörper 9 besteht in der Hauptsache aus einem keramischen Material. In dem Grundkörper 9 befindet sich ein elektrisch aktiver Bereich 3, der die für das Keramikbauelement vorgesehene Funktion wesentlich bestimmt und entsprechend aufgebaut ist und insbesondere Innenelektroden aufweisen kann. Der aktive Bereich 3 kann beispielsweise ein Stapel aus Schichten sein, die abwechselnd aus Metall und aus dielektrischem keramischem Material sind. Andere Materialien, die in dem aktiven Bereich 3 verwendet sein können, sind zum Beispiel PTC-Material, dessen elektrischer Widerstand bei Erhöhung der Temperatur zunimmt, NTC-Material, dessen elektrischer Widerstand bei Erhöhung der Temperatur abnimmt, Varistorkeramik, deren elektrischer Widerstand spannungsabhängig ist, Ferrit, Halbleitermaterial, Polymer oder dergleichen. Die Innenelektroden können zum Beispiel einander überlappend oder kammartig miteinander verzahnt angeordnet sein. Derartige Materialien und Anordnungen sind von Vielschichtbauelementen an sich bekannt.

Der Grundkörper 9 kann grundsätzlich beliebig geformt, zum Beispiel quaderförmig und insbesondere länglich sein. Der aktive Bereich 3 erstreckt sich im Fall eines länglichen Grundkörpers 9 vorzugsweise in der Längsrichtung des Grundkörpers 9, die in dem Beispiel der Figur 1 waagrecht verläuft. In diesem Ausführungsbeispiel befinden sich auf den in der Längsrichtung einander gegenüberliegenden Endflächen des Grundkörpers 9 voneinander getrennte Außenkontakte 1, 1', die auf je einer der Endfläche des Grundkörpers 9 angeordnet sind und dort insbesondere auch die Kanten des Grundkörpers 9 bedecken können, wie in der Figur 1 gezeigt ist. Zwischen den Außenkontakten 1, 1' und dem aktiven Bereich 3 befindet sich je ein Zuleitungsbereich 2, 2', in dem eine elektrisch leitende Verbindung zwischen einem elektrischen Anschluss oder Innenelektroden des aktiven Bereiches 3 und dem betreffenden Außenkontakt 1, 1' verläuft. Diese elektrisch leitende Verbindung kann durch einen einfachen elektrischen Leiter gebildet sein, zum Beispiel durch einen Leiterstreifen, der in einer Metallschicht strukturiert ist, oder auch eine Struktur aus mehreren Leitern aufweisen, womit zum Beispiel der Zuleitungswiderstand reduziert werden kann. Durch die Schraffuren der Zuleitungsbereiche 2, 2' und des aktiven Bereiches 3 wird in den Figuren angedeutet, dass diese Bereiche eine innere Struktur entsprechend der vorgesehenen Funktion des Keramikbauelementes aufweisen. Die Zuleitungsbereiche 2, 2' und der aktive Bereich 3 sind nur schematisch dargestellt und müssen nicht die in den Figuren eingezeichneten Abmessungen und Begrenzungen einnehmen.

Die Zuleitungsbereiche 2, 2' sind mit Elektroden 4, 4', 5, 5', 6, 6' abgeschirmt. Die Elektroden 4, 4', 5, 5', 6, 6' befinden sich jeweils benachbart zu dem betreffenden Zuleitungsbereich 2, 2' und sind mit dem betreffenden Außenkontakt 1, 1' elektrisch leitend verbunden. Das wird aus dem in der Figur 1 markierten Querschnitt gemäß der Figur 2 deutlich.

Die Figur 2 zeigt den in der Figur 1 markierten Querschnitt. Der Außenkontakt 1 befindet sich auf einer Endfläche des Grundkörpers 9 und kann, wie in dem dargestellten Beispiel, allseits die Kanten des Grundkörpers 9, die diese Endfläche beranden, überdecken, so dass der Außenkontakt 1 im Bereich des Querschnitts gemäß der Figur 2 den Grundkörper 9 umschließt. Der Zuleitungsbereich 2 befindet sich im Innern des Grundkörpers 9 im Abstand zu den bezüglich der Längsrichtung seitlichen Außenseiten des Grundkörpers 9, die an die Endfläche angrenzen. Zwischen diesen seitlichen Außenseiten und dem Zuleitungsbereich 2 sind die Elektroden 4, 5, 6, 6" angeordnet, die den Zuleitungsbereich 2 abschirmen und mit dem Außenkontakt 1 elektrisch leitend verbunden sind. In dem dargestellten Beispiel sind die Elektroden 4, 5, 6, 6" an der Endfläche des Grundkörpers 9 mit dem Außenkontakt 1 elektrisch leitend verbunden. Es ist auch möglich, statt dessen oder zusätzlich eine elektrisch leitende Verbindung zwischen den Elektroden 4, 5, 6, 6" und dem seitlichen, in dem Querschnitt der Figur 2 erkennbaren Anteil des Außenkontaktes 1 vorzusehen.

Die Elektroden 4, 5, 6, 6" können in einem Abstand zu dem Zuleitungsbereich 2 angeordnet sein, wie in der Figur 2 erkennbar ist. Die Elektroden 4, 5, 6, 6" sind in diesem Ausführungsbeispiel als Platten ausgebildet und koplanar in Abständen zueinander angeordnet und umgeben zumindest den Zuleitungsbereich 2 in den in Bezug auf die Längsrichtung seitlichen Richtungen, also dort, wo der Zuleitungsbereich 2 weder an den Außenkontakt 1 noch an den aktiven Bereich 3 angrenzt. In der Figur 1 ist erkennbar, dass die Elektroden 4, 5, 6, 6" so weit in das Innere des Grundkörpers 9 hinein reichen können, dass sie auch einen Teil des aktiven Bereiches 3 abschirmen.

Die in der Figur 2 untere Elektrode 4 und die in der Figur 2 obere Elektrode 5 sind so angeordnet, dass die flächige Ausdehnung dieser Elektroden 4, 5 die Abschirmung des Zuleitungsbereiches 2 bewirkt. Die seitlich angeordneten Elektroden 6, 6" sind entsprechend einer Schichtstruktur des Grundkörpers 9 koplanar zu den oben und unten vorhandenen Elektroden 4, 5 in ausreichend geringen Abständen zueinander angeordnet, so dass sie als Faradayscher Käfig wirken und somit eine für den vorgesehenen Zweck ausreichende Abschirmung bewirken.

Die Figur 3 zeigt einen Querschnitt eines weiteren Ausführungsbeispiels, das weitere Außenkontakte 1'' (in Figur 4 gezeigt) und 1''' aufweist. Die weiteren Außenkontakte 1'', 1'" sind zwischen den einander gegenüberliegenden Endflächen des Grundkörpers 9 in einem bezüglich der Längsrichtung des Grundkörpers 9 mittleren Bereich getrennt von den bereits beschriebenen Außenkontakten 1, 1' angeordnet und werden im Folgenden zur Unterscheidung von den auf den Endflächen des Grundkörpers 9 angeordneten Außenkontakten 1, 1' als mittlere Außenkontakte 1'', 1''' bezeichnet.

Die Figur 4 zeigt den in der Figur 3 markierten Querschnitt. Darin ist erkennbar, dass zwischen den mittleren Außenkontakten 1'', 1''' und dem aktiven Bereich 3 jeweils weitere Zuleitungsbereiche 2'', 2''' vorhanden sind, die den aktiven Bereich 3 mit dem betreffenden mittleren Außenkontakt 1'', 1'" verbinden. Zur elektrischen Abschirmung vorgesehene weitere Elektroden 7'', 8'', 7''', 8''' sind benachbart zu diesen mittleren Zuleitungsbereichen 2'', 2''' angeordnet und mit dem betreffenden mittleren Außenkontakt 1'', 1'" elektrisch leitend verbunden. In diesem Beispiel sind diese mittleren Elektroden 7'', 8'', 7''', 8''' jeweils Platten, die über und unter einer von dem aktiven Bereich 3 und den mittleren Zuleitungsbereichen 2'', 2''' eingenommenen Schichtlage des Grundkörpers 9 angeordnet sind. Die zur Abschirmung vorgesehenen mittleren Elektroden 7'', 8'', 7''', 8'" können innerhalb des Grundkörpers 9 in Abständen zu den mittleren Zuleitungsbereichen 2'', 2''' angeordnet sein.

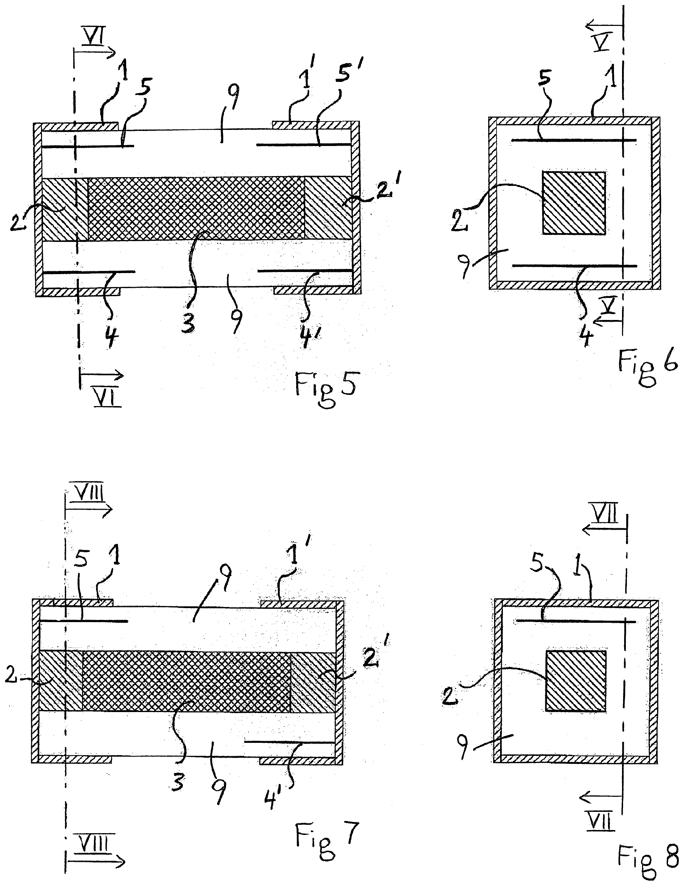

Die Figur 5 zeigt einen Querschnitt eines weiteren Ausführungsbeispiels, in dem die Anordnung der abschirmenden Elektroden 4, 4', 5, 5' gegenüber dem Ausführungsbeispiel gemäß der Figur 1 vereinfacht ist. In dem Ausführungsbeispiel gemäß der Figur 5 sind die seitlich angeordneten Elektroden 6, 6" weggelassen.

Die Figur 6 zeigt den in der Figur 5 markierten Querschnitt. Darin ist erkennbar, dass bei diesem Ausführungsbeispiel eine Abschirmung des Zuleitungsbereichs 2 in zwei zueinander entgegengesetzten Richtungen mittels der in der Figur 6 unteren Elektrode 4 und der in der Figur 6 oberen Elektrode 5 vorgesehen ist.

Die Figur 7 zeigt einen Querschnitt eines weiteren Ausführungsbeispiels, in dem die Anordnung der abschirmenden Elektroden 4', 5, gegenüber dem Ausführungsbeispiel gemäß der Figur 5 nochmals vereinfacht ist. In dem Ausführungsbeispiel gemäß der Figur 7 befindet sich an einem Ende des Grundkörpers 9 nur eine obere abschirmende Elektrode 5 und am gegenüberliegenden Ende des Grundkörpers 9 nur eine untere abschirmende Elektrode 4'. Die seitlich angeordneten Elektroden 6, 6" sind hier ebenfalls weggelassen.

Die Figur 8 zeigt den in der Figur 7 markierten Querschnitt. Darin ist erkennbar, dass bei diesem Ausführungsbeispiel eine Abschirmung des in der Figur 7 links eingezeichneten Zuleitungsbereiches 2 nur mittels der in der Figur 8 oberen Elektrode 5 vorgesehen ist. Eine Abschirmung des in der Figur 7 rechts eingezeichneten Zuleitungsbereiches 2' ist dementsprechend nur mittels der in der Figur 7 eingezeichneten unteren Elektrode 4' vorgesehen.

Bei allen dargestellten Ausführungsbeispielen ist eine Symmetrie der Anordnung der abschirmenden Elektroden 4, 4', 5, 5', 6, 6', 6'', 7'', 7''', 8'', 8''' in Bezug auf den aktiven Bereich 3 und die zu dem aktiven Bereich 3 führenden Zuleitungsbereiche 2, 2', 2'', 2'" vorhanden. Diese Symmetrie ist bei den Ausführungbeispielen der Figuren 1 bis 6 eine Spiegelsymmetrie und bei dem Ausführungsbeispiel der Figuren 7 und 8 eine Achsensymmetrie bezüglich einer Rotation um 180°. Die Symmetrieachse steht senkrecht auf der Zeichenebene der Figur 7 und verläuft durch die Mitte des Keramikbauelementes.

### Bezugszeichenliste

- 1: Außenkontakt
- 1': Außenkontakt
- 1": mittlerer Außenkontakt
- 1''': mittlerer Außenkontakt
- 2: Zuleitungsbereich
- 2': Zuleitungsbereich
- 2": mittlerer Zuleitungsbereich
- 2''': mittlerer Zuleitungsbereich
- 3: aktiver Bereich
- 4: Elektrode
- 4': Elektrode
- 5: Elektrode
- 5': Elektrode
- 6: Elektrode
- 6': Elektrode
- 6": Elektrode
- 7'': mittlere Elektrode
- 7''': mittlere Elektrode
- 8'': mittlere Elektrode
- 8''': mittlere Elektrode
- 9: Grundkörper

## Patentansprüche

1. Elektrisches Keramikbauelement mit
- einem Grundkörper (9) aus dielektrischem Material, in dem ein aktiver Bereich (3) angeordnet ist,
- einem Außenkontakt (1), der an dem Grundkörper (9) angeordnet ist, und einem weiteren Außenkontakt (1'), der an einer dem Außenkontakt (1) gegenüberliegenden Seite des Grundkörpers (9) angeordnet ist,
- einem Zuleitungsbereich (2), der den Außenkontakt (1) mit dem aktiven Bereich (3) verbindet, und einem weiteren Zuleitungsbereich (2'), der den weiteren Außenkontakt (1') mit dem aktiven Bereich (3) verbindet,
- Elektroden (4, 5, 6, 6''), die als Platten ausgebildet und in zueinander parallelen Ebenen in Abständen zueinander und benachbart zu dem Zuleitungsbereich (2) in dem Grundkörper (9) angeordnet sind und mit dem Außenkontakt (1), aber nicht mit dem aktiven Bereich (3) elektrisch leitend verbunden sind, so dass sie den Zuleitungsbereich (2) dort als Faradayscher Käfig rings umgeben, wo der Zuleitungsbereich (2) weder an den Außenkontakt (1) noch an den aktiven Bereich (3) angrenzt,
- weitere Elektroden (4', 5', 6'), die als Platten ausgebildet und in zueinander parallelen Ebenen in Abständen zueinander und benachbart zu dem weiteren Zuleitungsbereich (2') in dem Grundkörper (9) angeordnet sind und mit dem weiteren Außenkontakt (1'), aber nicht mit dem aktiven Bereich (3) elektrisch leitend verbunden sind, so dass sie den weiteren Zuleitungsbereich (2') dort als Faradayscher Käfig rings umgeben, wo der weitere Zuleitungsbereich (2') weder an den weiteren Außenkontakt (1') noch an den aktiven Bereich (3) angrenzt,
**dadurch gekennzeichnet, dass**
- zwischen dem Außenkontakt (1) und dem weiteren Außenkontakt (1') ein mittlerer Außenkontakt (1'') an dem Grundkörper (9) angeordnet ist,
- ein mittlerer Zuleitungsbereich (2'') vorhanden ist, der den mittleren Außenkontakt (1'') mit dem aktiven Bereich (3) verbindet, und
- eine mittlere Elektrode (7'') als Platte ausgebildet und benachbart zu dem mittleren Zuleitungsbereich (2'') und in einem Abstand zu dem mittleren Zuleitungsbereich (2'') in dem Grundkörper (9) angeordnet und mit dem mittleren Außenkontakt (1''), aber nicht mit dem aktiven Bereich (3) elektrisch leitend verbunden ist.

2. Elektrisches Keramikbauelement nach Anspruch 1, bei dem auf einer der mittleren Elektrode (7'') gegenüberliegenden Seite des mittleren Zuleitungsbereiches (2'') eine weitere mittlere Elektrode (8'') benachbart zu dem mittleren Zuleitungsbereich (2'') in dem Grundkörper (9) angeordnet und mit dem mittleren Außenkontakt (1''), aber nicht mit dem aktiven Bereich (3) elektrisch leitend verbunden ist.

3. Elektrisches Keramikbauelement nach Anspruch 1 oder 2, bei dem
die benachbart zu dem Zuleitungsbereich (2) und zu dem weiteren Zuleitungsbereich (2') angeordneten Elektroden (4, 4', 5, 5', 6, 6', 6'') eine in Bezug auf den aktiven Bereich (3) symmetrische Anordnung bilden.

4. Elektrisches Keramikbauelement nach einem der Ansprüche 1 bis 3, bei dem
- zwischen dem Außenkontakt (1) und dem weiteren Außenkontakt (1') ein weiterer mittlerer Außenkontakt (1''') an dem Grundkörper (9) angeordnet ist,
- ein weiterer mittlerer Zuleitungsbereich (2''') vorhanden ist, der den weiteren mittleren Außenkontakt (1''') mit dem aktiven Bereich (3) verbindet und auf einer dem mittleren Zuleitungsbereich (2'') gegenüberliegenden Seite des aktiven Bereiches (3) angeordnet ist, und
- eine weitere mittlere Elektrode (7''') als Platte ausgebildet und benachbart zu dem weiteren mittleren Zuleitungsbereich (2''') und in einem Abstand zu dem weiteren mittleren Zuleitungsbereich (2''') in dem Grundkörper (9) angeordnet und mit dem weiteren mittleren Außenkontakt (1'''), aber nicht mit dem aktiven Bereich (3) elektrisch leitend verbunden ist.

5. Elektrisches Keramikbauelement nach Anspruch 4, bei dem auf einer der weiteren mittleren Elektrode (7'''), die zu dem weiteren mittleren Zuleitungsbereich (2''') benachbart angeordnet ist, gegenüberliegenden Seite des weiteren mittleren Zuleitungsbereiches (2''') eine weitere mittlere Elektrode (8''') benachbart zu dem weiteren mittleren Zuleitungsbereich (2''') in dem Grundkörper (9) angeordnet und mit dem weiteren mittleren Außenkontakt (1'''), aber nicht mit dem aktiven Bereich (3) elektrisch leitend verbunden ist.

## Claims

1. Electric ceramic component having
- a base body (9) made of a dielectric material, in which an active region (3) is arranged,
- an outer contact (1), which is arranged on the base body (9), and a further outer contact (1'), which is arranged on an opposite side of the base body (9) from the outer contact (1),
- a supply region (2), which connects the outer contact (1) to the active region (3), and a further supply region (2'), which connects the further outer contact (1') to the active region (3),
- electrodes (4, 5, 6, 6"), which are formed as plates and are arranged in mutually parallel planes at distances from one another and arranged next to the supply region (2) in the base body (9) and are electrically conductively connected to the outer contact (1), but not to the active region (3), so that they surround the supply region (2) there as a Faraday cage in a ring, where the supply region (2) is not adjacent to the outer contact (1) or the active region (3),
- further electrodes (4', 5', 6'), which are formed as plates and are arranged in mutually parallel planes at distances from one another and arranged next to the further supply region (2') in the base body (9) and are electrically conductively connected to the further outer contact (1'), but not to the active region (3), so that they surround the further supply region (2') there as a Faraday cage in a ring, where the further supply region (2') is not adjacent to the further outer contact (1') or the active region (3),
**characterized in that**
- a central outer contact (1") is arranged between the outer contact (1) and the further outer contact (1') on the base body (9),
- a central supply region (2") is provided, which connects the central outer contact (1'') to the active region (3), and
- a central electrode (7") is formed as a plate and is arranged next to the central supply region (2") and at a distance from the central supply region (2") in the base body (9) and is electrically conductively connected to the central outer contact (1"), but not to the active region (3).

2. Electric ceramic component according to Claim 1, wherein, on an opposite side of the central supply region (2") from the central electrode (7"), a further central electrode (8") is arranged next to the central supply region (2") in the base body (9) and is electrically conductively connected to the central outer contact (1"), but not to the active region (3).

3. Electric ceramic component according to Claim 1 or 2, wherein the electrodes (4, 4', 5, 5', 6, 6', 6'') arranged next to the supply region (2) and the further supply region (2') form a symmetrical arrangement in relation to the active region (3).

4. Electric ceramic component according to one of Claims 1 to 3, wherein
- a further central outer contact {!''') is arranged between the outer contact (1) and the further outer contact (1') on the base body (9),
- a further central supply region (2''') is provided, which connects the further central outer contact (1''') to the active region (3) and is arranged on an opposite side of the active region (3) from the central supply region (2"), and
- a further central electrode (7"') is formed as a plate and is arranged next to the further central supply region (2''') and at a distance from the further central supply region (2''') in the base body (9) and is electrically conductively connected to the further central outer contact (1"'), but not to the active region (3).

5. Electric ceramic component according to Claim 4, wherein, on an opposite side of the further central supply region (2''') from the further central electrode (7"'), which is arranged next to the further central supply region (2"'), a further central electrode (8''') is arranged next to the further central supply region (2''') in the base body (9) and is electrically conductively connected to the further central outer contact (1"'), but not to the active region (3).

## Revendications

1. Composant électrique en céramique comportant
- un corps de base (9) en matériau diélectrique, dans lequel est disposée une zone active (3),
- un contact extérieur (1) qui est disposé sur le corps de base (9), et un autre contact extérieur (1') qui est disposé sur un côté du corps de base (9) qui est opposé au contact extérieur (1),
- une zone d'alimentation (2) qui relie le contact extérieur (1) à la zone active (3), et une autre zone d'alimentation (2') qui relie l'autre contact extérieur (1') à la zone active (3),
- des électrodes (4, 5, 6, 6'') qui sont réalisées sous forme de plaques et sont disposées dans le corps de base (9) dans des plans parallèles les uns aux autres espacés les uns des autres et voisins de la zone d'alimentation (2) et qui sont reliées de manière électriquement conductrice au contact extérieur (1) mais pas à la zone active (3), de manière à ce qu'elles entourent la zone d'alimentation (2) en formant une cage de Faraday, où la zone d'alimentation (2) n'est adjacente ni au contact extérieur (1), ni à la région active (3),
- d'autres électrodes (4', 5', 6') qui sont réalisées sous forme de plaques et sont disposées dans le corps de base (9) dans des plans parallèles les uns aux autres espacés les uns des autres et voisins de l'autre zone d'alimentation (21) et qui sont reliées de manière électriquement conductrice à l'autre contact extérieur (1') mais pas à la zone active (3), de manière à ce qu'elles entourent l'autre zone d'alimentation (2') en formant une cage de Faraday, où l'autre zone d'alimentation (2') n'est adjacente ni à l'autre contact extérieur (1') ni à la zone active (3),
**caractérisé**
- **en ce qu'**un contact extérieur central (1'') est disposé sur le corps de base (9) entre le contact extérieur (1) et l'autre contact extérieur (1'),
- **en ce qu'**il est prévu une zone d'alimentation centrale (2'') qui relie le contact extérieur central (1'') à la zone active (3), et
- **en ce qu'**une électrode centrale (7'') est réalisée sous la forme d'une plaque et est disposée dans le corps de base (9) de manière adjacente à la zone d'alimentation centrale (2'') et de manière espacée de la zone d'alimentation centrale (2'') et est reliée de manière électriquement conductrice au contact extérieur central (1'') mais pas à la zone active (3).

2. Composant électrique en céramique selon la revendication 1, dans lequel une autre électrode centrale (8'') est disposée dans le corps de base (9) sur un côté de la zone d'alimentation centrale (2'') qui est opposé à l'électrode centrale (7'') de manière adjacente à la zone d'alimentation centrale (2'') et est reliée de manière électriquement conductrice au contact extérieur central (1'') mais pas à la zone active (3).

3. Composant électrique en céramique selon la revendication 1 ou 2, dans lequel
les électrodes (4, 4', 5, 5', 6, 6', 6'') disposées de manière adjacente à la zone d'alimentation (2) et à l'autre zone d'alimentation (2') forment un agencement symétrique par rapport à la zone active (3).

4. Composant électrique en céramique selon l'une des revendications 1 à 3, dans lequel
- un autre contact extérieur central (1''') est disposé sur le corps de base (9) entre le contact extérieur (1) et l'autre contact extérieur (1'),
- il est prévu une autre zone d'alimentation centrale (2''') qui relie l'autre contact extérieur central (1"') à la zone active (3) et qui est disposée sur un côté de la zone active (3) qui est opposé à la zone d'alimentation centrale (2''), et
- une autre électrode centrale (7''') est réalisée sous forme d'une plaque et est disposée dans le corps de base (9) de manière adjacente à l'autre zone d'alimentation centrale (2''') et de manière espacée de l'autre zone d'alimentation centrale (2''') et est reliée de manière électriquement conductrice à l'autre contact extérieur central (1''') mais pas à la zone active (3).

5. Composant électrique en céramique selon la revendication 4, dans lequel une autre électrode centrale (8''') est disposée dans le corps de base (9) de manière adjacente à l'autre zone d'alimentation centrale (2'''), sur un côté de l'autre zone d'alimentation centrale (2''') qui est opposé à l'autre électrode centrale (7'''), qui est disposée de manière adjacente à l'autre zone d'alimentation centrale (2'''), et est reliée de manière électriquement conductrice à l'autre contact extérieur central (1''') mais pas à la zone active (3).
